# EUROPEAN PATENT SPECIFICATION

(11) **EP 1 482 554 B1**
(45) Date of publication and mention of the grant of the patent: **01.03.2006**
(21) Application number: 03447134.2
(22) Date of filing: 28.05.2003
(51) Int. Cl.: H01L 27/02, H02H 9/04

(54) **Electrostatic discharge protection device**
Schutzvorrichtung gegen elektrostatische Entladungen
Dispositif de protection contre les décharges électrostatiques

(43) Date of publication of application: 01.12.2004
(73) Proprietor: INTERUNIVERSITAIR MICROELEKTRONICA CENTRUM ( IMEC), 3001 Leuven (BE); AMI Semiconductor Belgium BVBA, 9700 Oudenaarde (BE)
(72) Inventor: Reynders, Koen, 9700 Oudenaarde (BE); De Heyn, Vincent, 4260 Braives (BE); Zubeidat, Mahmud, 9000 Gent (BE)
(74) Representative: Van Malderen, Joelle

(56) References cited:
- EP-A- 0 651 490
- EP-A- 0 892 436
- DD-A- 298 715
- US-A1- 2002 060 890
- SPONTON L ET AL: "ESD protection structures for BCD5 smart power technologies" 12TH EUROPEAN SYMPOSIUM ON THE RELIABILITY OF ELECTRON DEVICES, FAILURE PHYSICS AND ANALYSIS (ESREF 2001), BORDEAUX, FRANCE, 1-5 OCT. 2001, vol. 41, no. 9-10, pages 1683-1687, XP002257145 Microelectronics Reliability, Sept.-Oct. 2001, Elsevier, UK ISSN: 0026-2714

## Description

### Field of the invention

The present invention is related to a device for protection of an electronic circuit from Electrostatic Discharge (ESD) events.

### State of the art

ESD protection devices are crucial to the failure-proof operations of many electronic devices. IC-devices in particular need to be protected against ESD pulses occurring on the supply line to such devices.

In general, supply protection elements are added on-chip, in order to keep ESD pulses from damaging the IC's during any manipulation. Many of such elements exhibit a so-called 'snap-back' behaviour, as soon as a given voltage level is exceeded. Supply protections require a special feature : they have to be latch-up safe. When supply protection devices with a snapback behaviour are used, the holding voltage of this device must be higher than the supply voltage (V_{DD}). In a harsh automotive environment, supply protections can trigger during normal operation due to accidental over voltages. If the supply protection would clamp the voltage to a value below the operating voltage, the protection would latch and burn due to a large DC supply current. Therefore a high holding voltage is critical for supply protections.

In the automotive industry, 42V battery supply voltage is becoming the new standard, requiring a supply protection with a holding voltage of at least 50V. Combined with the requirement of high current capability (>4kV HBM), supply protections with a power capability of minimum 150W power dissipation during 100ns are necessary. A device which is known in this respect is the so-called 'Active Clamp', which is basically a bipolar or DMOS transistor of over-dimensioned size, capable of operating under very high ESD currents. This is however not a snap-back device, and requires a large and therefore Silicon-expensive area.

Document US2002/0060890 is related to an ESD protection device comprising a plurality of bipolar transistors coupled between a protected node and a common node, wherein a resistor is coupled between the bases of two neighbouring transistors, and a resistor is equally coupled between the base of the bottom transistor and the common node. A similar structure is disclosed in document EP-A-651490.

In the document entitled 'ESD protection structures for BCD5 smart power technologies', Microelectronics Reliability, 41 (2001), p. 1683-1687, the use of a Darlington pair of DMOS transistors is described for the improvement of ESD protection.

### Aims of the invention

The present invention aims to provide a compact ESD protection device exhibiting a snap-back behaviour with a holding voltage of at least 50V.

### Summary of the invention

The present invention is related to a device for the protection of an electronic circuit from Electrostatic Discharge (ESD), said circuit being supplied by a supply voltage (V_{DD}), with respect to a reference voltage (Vₛₛ), said device comprising a set of at least two bipolar transistors coupled in series, two neighbouring transistors being connected through a first connection between the collector of one transistor and the emitter of the other transistor, said set of at least two transistors in series being further provided with a first terminal, for connection to the supply voltage (V_{DD}), one of the transistors being directly connected to said first terminal, and a second terminal for connection to the reference voltage (Vₛₛ), wherein the bases of every two neighbouring transistors are interconnected by a second connection comprising a resistor (R1), characterized in that said second connection between the bases comprises two resistors, coupled in series through a third connection, and wherein a fourth connection is coupled between said first and third connection.

A device of the invention may further comprise one or more capacitors, each capacitor being coupled between said first terminal, to which one of the transistors is directly connected, and the base of one or more of the other transistors.

Alternatively, a device of the invention may further comprise one or more gate coupled DMOS transistors, each DMOS transistor being coupled between said first terminal, to which one of the transistors is directly connected, and the base of one or more of the other transistors.

The invention is equally related to an electronic device, protected by at least one device according to the previous claims.

### Short description of the drawings

Fig. 1 represents a prior art ESD protection device comprising a single bipolar transistor. Figure 1a shows the electrical equivalent; figure 1b shows the physical model.

Fig. 2 represents a typical 'snap-back' I-V characteristic of an ESD protection device of the prior art.

Fig. 3 represents a schematic view of an ESD protection device according to the invention. Figure 3a shows the electrical equivalent; figure 3b shows the physical model.

Fig. 4 represents the I-V characteristic of a device according to the invention.

Fig. 5 and 6 represent further embodiments of the device of the invention.

Fig. 7 represents a practical implementation of a device according to the invention.

Fig. 8 represents a device of the invention, comprising three bipolar transistors.

### Detailed description of the invention

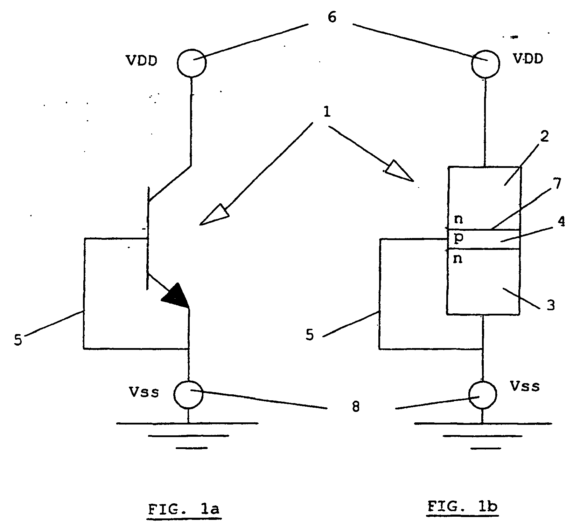

Figure 1a and 1b show a prior art ESD protection device based on one bipolar npn transistor 1, coupled, like the protected devices (not shown), between a reference voltage Vₛₛ at terminal 8, corresponding normally to ground, and a supply voltage V_{DD} at terminal 6. Figure 1a shows the electrical equivalent, figure 1b the physical model. Vₛₛ and V_{DD} are respectively present on the collector 2 and the emitter 3 of the transistor 1. The base 4 is connected to the emitter 3 by way of a conductor 5.

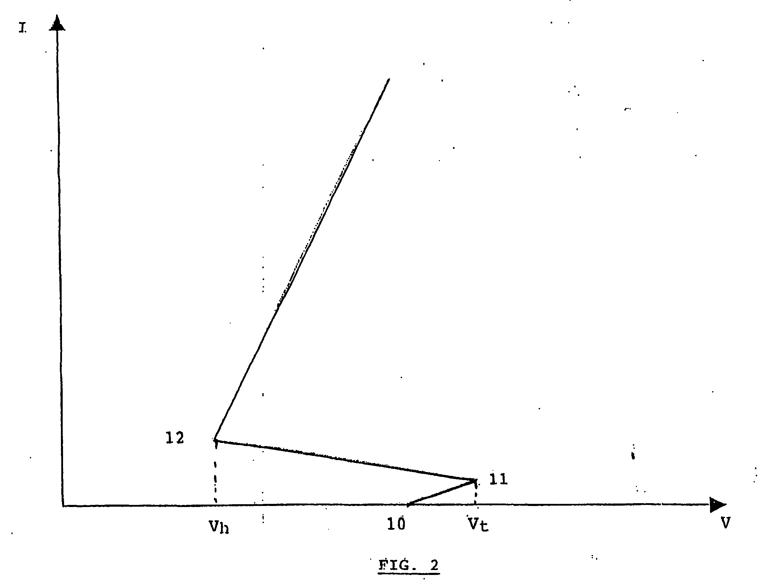

The operation of such a device is illustrated by its I-V characteristic, see fig. 2. As the voltage on the supply terminal 6 increases, the junction 7 between the collector and the base breaks down (point 10 on figure 2), causing a current to flow through the conductor 5. Due to the internal resistance of this conductor, a voltage will be built up between the base 4 and emitter 3. When this voltage reaches about 0.7V, the bipolar transistor is turned on, and the device goes into the snapback mode, see points 11 and 12 on the characteristic. In this mode, starting from point 12, the device exhibits a low resistance and is able to receive a large current, which would otherwise damage the protected devices.

The snap-back curve is characterized by two important points : the snap-back point 11, corresponding to the so-called trigger voltage Vt, and the start of the low resistance mode at point 12, corresponding to the so-called holding voltage Vh. This holding voltage depends on the technology and it is generally not possible to achieve the high holding voltage requirements by means of a single vertical bipolar transistor. The device of figure 1 usually has a holding voltage of about 25V at the most, which is insufficient with regard to new requirements, as discussed in the previous paragraph. The holding voltage needs to be doubled at least.

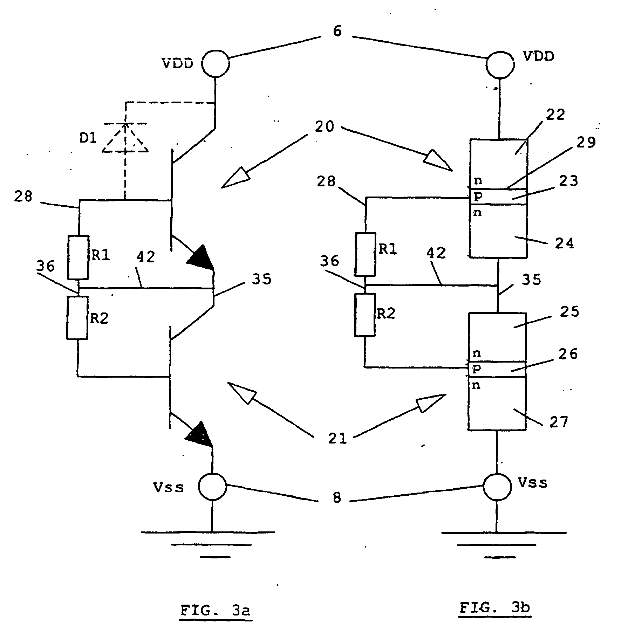

The invention provides a solution to this problem by providing a device comprising at least two bipolar transistors in series, with the addition of a connection between the bases of said two transistors. In the following, the embodiment with two transistors is described. However, more than two transistors in series can be applied, as explained at the end of this description. The device of the invention exhibits, depending on the precise design parameters, a holding voltage of at least 50V, and a trigger voltage of less than 80V. Figure 3 shows a schematic view of a device according to the invention.

The device of figure 3 comprises two bipolar npn transistors 20 and 21. The collector 22 of the first transistor 20 is connected to the terminal 6 which is to be connected to the supply voltage V_{DD}. The emitter 24 of said first transistor 20 is connected to the collector 25 of the second transistor 21, through series connection 35. The emitter 27 of the second transistor 21 is connected at the second terminal 8 to a reference voltage Vₛₛ, preferably ground.

The bases 23 and 26 of both bipolar transistors 20 and 21 are connected to each other by a connection 28. The connection 28 comprises a second resistor R2 coupled in series to the first resistor R1 by connection 36. Furthermore, a connection 42 is coupled between connection 36 (located between the resistors) and connection 35 (located between the transistors).

The operation of the device of figure 3 can be explained as follows. In the off state, the collector/base junction 29 of transistor 20 sustains the complete voltage between terminals 6 and 8. This junction is represented by the collector base diode D1. When this junction breaks down, a current is flowing to the base 26 of transistor 21 which will go into the on-state. When the avalanche current reaches a certain value, transistor 20 goes into snapback. The steep voltage decrease over transistor 20 is then compensated by the voltage drop over transistor 21 which is still in the on-state. This voltage drop depends on the amount of current which is flowing to the base of transistor 21. This current can be controlled by resistors R1 and R2. At a higher current level, transistor 21 also goes into a high current regime so that both transistors now work in this high current regime. The total voltage is then equally divided over the 2 transistors.

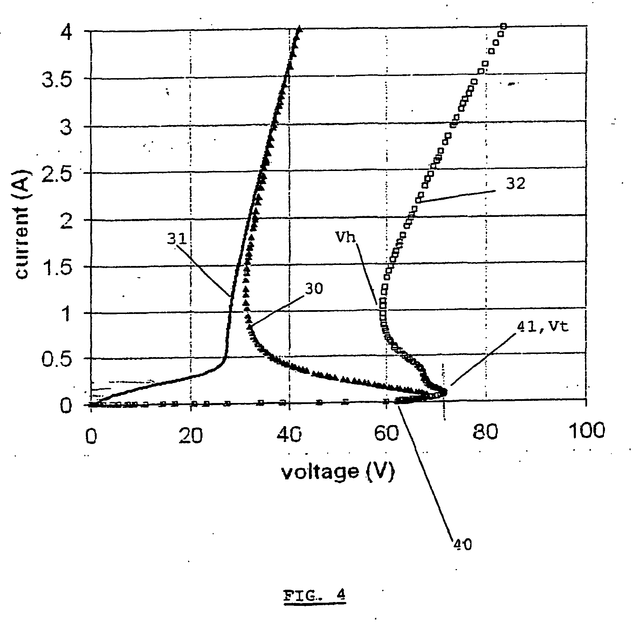

Figure 4 shows the IV-characteristic of the device of figure 3, see curve 32. This curve is the sum of the curves 30 and 31, which represent the behaviour of transistors 20 and 21 respectively. Curve 31 will develop only as soon as the total voltage reaches point 40. At this point, the junction diode D1 goes into breakdown, causing the transistor 21 to start conducting, developing a voltage along curve 31. Since this voltage is low at the initial low current levels, the total triggering voltage Vt, reached when transistor 20 goes into snap-back (point 41) will not be high, thereby avoiding overshoot problems.

At higher current levels, the holding voltage Vh is the sum of the holding voltage of the transistor 20 in snapback, and the voltage over transistor 21, which is higher at higher current levels, making the total holding voltage Vh higher than in the case of a single transistor. The device of figure 3 represents an improvement over the prior art in that the connection 42 allows the current coming from the base of transistor 20 to be diverted into the collector 25 of transistor 21, so that the voltage over transistor 21 can be directly controlled via the second resistor R2.

In general, an adequate design of the parameters R1 and R2, and of the transistors 20 and 21 allows the objectives to be reached, namely a holding voltage of at least 50V and a triggering voltage of maximum 80V, depending on the application.

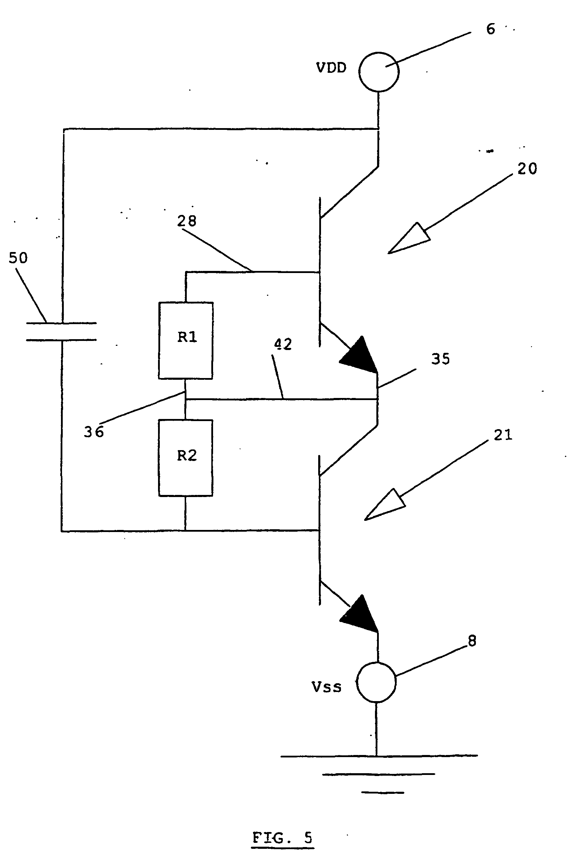

Other components might be added to the device of figure 3. For example, a capacitor 50 can be added between the collector of transistor 20 and the base of transistor 21, to limit the dynamic overshoot, see figure 5.

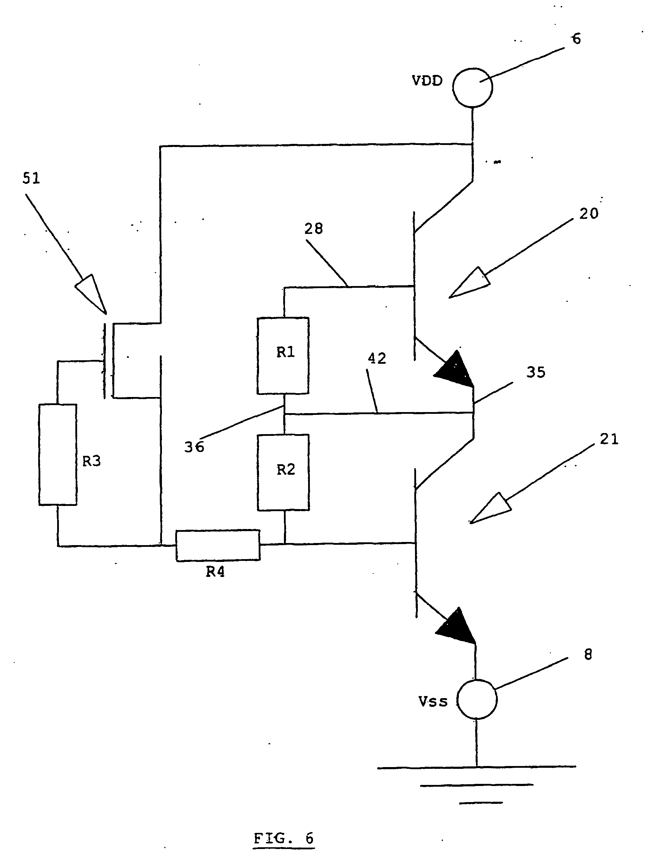

Another embodiment, shown in figure 6, comprises a base coupled VDMOS transistor 51, between the collector of transistor 20 and the base of transistor 21. R3 is an external base resistance to make a gate coupled VDMOS which triggers via drain-to-gate coupling during the rising edge of an ESD event. R4 is a current limiter to avoid full discharge through the DMOS when this goes into snapback.

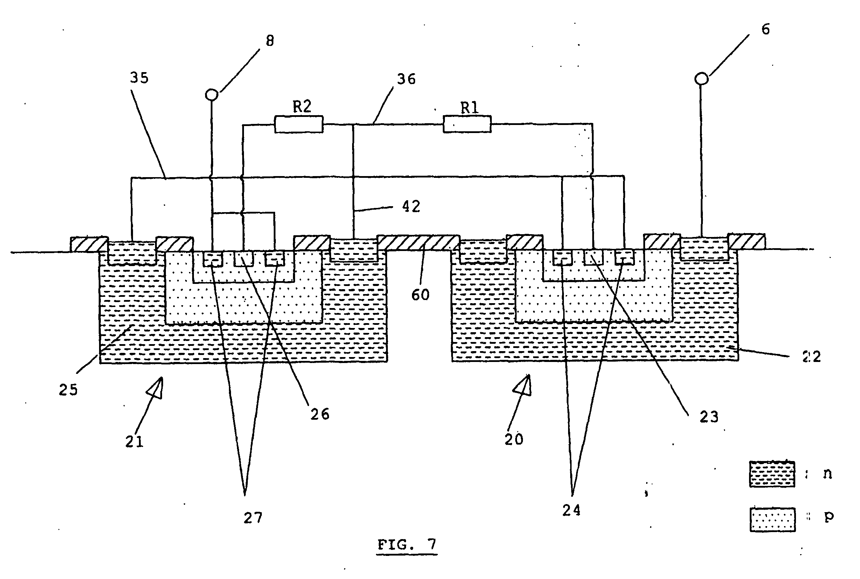

In every embodiment according to the invention, a set of pnp transistors may be used in stead of npn-transistors. An ESD protection device according to the invention is preferably built on-chip within a given semiconductor technology and has a physical structure which is adapted to such technology. Figure 7 finally shows an example of such an implementation. The same numerals are used to indicate the same components. The npn-transistors are of the symmetrical type, each having two emitters and two collectors. The isolation between the two transistors can be obtained by any known means, for example by a field oxide 60. An ESD pulse may arrive at the terminal 6. The connection 35 is recognizable, as well as the connection 42. It is clear that other physical implementations of the transistors may be used, without leaving the scope of the invention. The schematic representation of figure 3 is the basis of any device of the present invention. It is also possible to arrive at a device of the invention by combining so called 'parasitic' bipolar transistors, which are formed for example in an NMOS/DMOS structure by the n-implant of the source and drain, playing the part of emitter and collector, and the p-well/p-body, playing the part of the base.

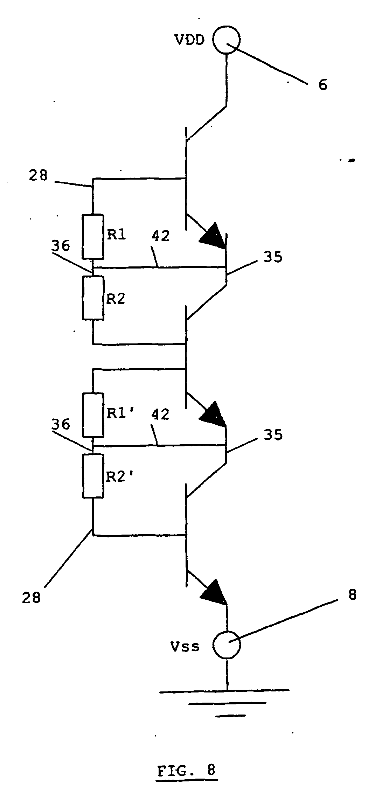

Fig. 8 shows an embodiment with three transistors in series. During operation, the upper transistor in fig. 8 will go into snapback, thereby causing both of the lower transistors to be activated. The invention is characterized by the presence of a connection 28 between the bases of every two neighbouring transistors in the series, each connection 28 comprising the two resistors R1/R2 or R1'/R2', plus the connection 42. A capacitor or DMOS transistor between the terminal 6 and the base of every transistor in the series is optional. The holding voltage of the device of figure 8 is the determined by the combined effect of the three transistors, and can be tuned as described above, for example through the values of the resistors.

## Claims

1. A device for the protection of an electronic circuit from Electrostatic Discharge (ESD), said circuit being supplied by a supply voltage (V_{DD}), with respect to a reference voltage (Vₛₛ), said device comprising a set of at least two bipolar transistors (20,21) coupled in series, two neighbouring transistors being connected through a first connection (35) between the collector (25) of one transistor and the emitter (24) of the other transistor, said set of at least two transistors in series being further provided with a first terminal (6), for connection to the supply voltage (V_{DD}) one of the transistors (20) being directly connected to said first terminal, and a second terminal (8) for connection to the reference voltage (Vₛₛ), wherein the bases (23, 26) of every two neighbouring transistors are interconnected by a second connection (28),
**characterized in that** said second connection (28) between the bases (23,26) comprises two resistors (R1, R2), coupled in series through a third connection (36), and wherein a fourth connection (42) is coupled between said first and third connection (35,36).

2. A device according to claim 1, further comprising one or more capacitors (50), each capacitor being coupled between said first terminal (6), to which one of the transistors (20) is directly connected, and the base of one or more of the other transistors (21).

3. A device according to claim 1, further comprising one or more gate coupled DMOS transistors, each DMOS transistor being coupled between said first terminal (6), to which one of the transistors (20) is directly connected, and the base of one or more of the other transistors (21).

4. An electronic device, protected by at least one device according to either one of the previous claims.

## Revendications

1. Dispositif pour la protection d'un circuit électronique contre une décharge électrostatique (ESD) (ESD = ElectroStatic Discharge), ledit circuit étant alimenté par une tension d'alimentation (V_{DD}), par rapport à une tension de référence (V_{SS}), ledit dispositif comprenant un jeu d'au moins deux transistors bipolaires (20, 21) couplés en série, deux transistors avoisinants étant connectés par une première connexion (35) entre le collecteur (25) d'un transistor et l'émetteur (24) de l'autre transistor, ledit jeu d'au moins deux transistors en série étant en outre muni d'un premier terminal (6), pour une connexion à la tension d'alimentation (V_{DD}), l'un des transistors (20) étant directement connecté audit premier terminal, et d'un deuxième terminal (8) pour une connexion à la tension de référence (vₛₛ), dans lequel les bases (23, 26) de chacun des deux transistors avoisinants sont interconnectées par une deuxième connexion (28),
**caractérisé en ce que** ladite deuxième connexion (28) entre les bases (23, 26) comprend deux résistances (R1, R2), couplées en série par une troisième connexion (36), et où une quatrième connexion (42) est couplée entre lesdites première et troisième connexions (35, 36).

2. Dispositif selon la revendication 1, comprenant en outre un ou plusieurs condensateurs (50), chaque condensateur étant couplé entre ledit premier terminal (6), auquel un des transistors (20) est directement connecté, et la base de l'un ou de plusieurs des autres transistors (21).

3. Dispositif selon la revendication 1, comprenant en outre un ou plusieurs transistors DMOS à grille couplée, chaque transistor DMOS étant couplé entre ledit premier terminal (6), auquel un des transistors (20) est directement connecté, et la base de l'un ou de plusieurs des autres transistors (21).

4. Dispositif électronique protégé par au moins un dispositif selon l'une quelconque des revendications précédentes.

## Patentansprüche

1. Vorrichtung zum Schutz eines elektronischen Schaltkreises gegen eine elektrostatische Entladung (ESD = ElectroStatic Discharge), wobei besagter Schaltkreis mit einer Versorgungsspannung (V_{DD}) versorgt wird, unter Inbetrachtnahme einer Referenz-Spannung (V_{SS}), wobei besagte Vorrichtung einen Satz von wenigstens zwei zweipoligen Transistoren (20, 21) umfasst, welche in Serie geschaltet sind, wobei zwei angrenzende Transistoren über eine erste Verbindung (35) zwischen dem Kollektor (25) eines Transistors und dem Emitter (24) des anderen Transistors geschaltet sind, wobei besagter Satz von wenigstens zwei Transistoren in Serie desweiteren mit einem ersten Anschluss (6) versehen ist zur Verbindung mit der Versorgungsspannung (V_{DD}), wobei einer der Transistoren (20) direkt mit besagtem ersten Anschluss verbunden ist, und mit einem zweiten Anschluss (8) zur Verbindung mit der Referenz-Spannung (V_{SS}), wobei die Basen (23, 26) eines jeden der zwei angrenzenden Transistoren durch eine zweite Verbindung (28) untereinander verbunden sind,
**dadurch gekennzeichnet, dass** besagte zweite Verbindung (28) zwischen den Basen (23, 26) zwei, über eine dritte Verbindung (36) in Serie geschaltete Widerstände (R1, R2) umfasst, und worin eine vierte Verbindung (42) zwischen den besagten ersten und dritten Verbindungen geschaltet ist.

2. Vorrichtung gemäss Anspruch 1, welche desweiteren einen oder mehr Kondensatoren (50) umfasst, wobei ein jeder Kondensator zwischen besagtem ersten Anschluss (6), mit welchem einer der Transistoren (20) direkt verbunden ist, und der Basis von einem oder von mehreren der anderen Transistoren (21) geschaltet ist.

3. Vorrichtung gemäss Anspruch 1, welche desweiteren einen oder mehr als Tor geschaltete DMOS Transistoren umfasst, wobei ein jeder der DMOS Transistoren zwischen besagtem ersten Anschluss (6), mit welchem einer der Transistoren (20) direkt verbunden ist, und der Basis von einem oder von mehreren der anderen Transistoren (21) geschaltet ist.

4. Elektronische Vorrichtung, welche durch wenigstens eine Vorrichtung gemäss irgendeinem der vorhergehenden Ansprüchen geschützt wird.
